# EUROPEAN PATENT APPLICATION

(11) **EP 3 206 228 A1**
(43) Date of publication of application: **16.08.2017**
(21) Application number: 17152734.4
(22) Date of filing: 24.01.2017
(51) Int. Cl.: H01L 23/498, H01L 21/48

(54) **SEMICONDUCTOR DEVICE ON SUBSTRATE WITH INTEGRATED PASSIVE COMPONENT AND ITS MANUFACTURE**

(30) Priority: 12.02.2016 US 201615043080
(71) Applicant: Semtech Corporation, Camarillo, CA 93012 (US)
(72) Inventor: CHINNUSAMY, Satyamoorthi, San Jose, CA 95135 (US); TAN, Weng Hing, San Jose, CA 95148 (US); REYES, Jayson Nathaniel S., Oxnard, CA 93030 (US)
(74) Representative: Grünecker Patent- und Rechtsanwälte PartG mbB

(57) **Abstract**

A semiconductor device includes a substrate and a first conductive layer formed over a first surface of the substrate. The first conductive layer is patterned into a first portion of a first passive circuit element. The first conductive layer is patterned to include a first coiled portion. A second conductive layer is formed over a second surface of the substrate. The second conductive layer is patterned into a second portion of the first passive circuit element. The second conductive layer is patterned to include a second coiled portion exhibiting mutual inductance with the first coiled portion. A conductive via formed through the substrate is coupled between the first conductive layer and second conductive layer. A semiconductor component is disposed over the substrate and electrically coupled to the first passive circuit element. An encapsulant is deposited over the semiconductor component and substrate. The substrate is mounted to a printed circuit board.

## Description

### Field of the Invention

The present invention relates in general to semiconductor devices and, more particularly, to a semiconductor device and method of forming a semiconductor device including a leadframe with an integrated passive component.

### Background

Semiconductor devices are commonly found in modern electronic products. Semiconductor devices vary in the number and density of electrical components. Discrete semiconductor devices generally contain one type of electrical component, e.g., light emitting diode (LED), small signal transistor, resistor, capacitor, inductor, and power metal-oxide-semiconductor field-effect transistor (MOSFET). Integrated semiconductor devices typically contain hundreds to millions of electrical components. Examples of integrated semiconductor devices include microcontrollers, microprocessors, and various signal processing circuits.

Semiconductor devices perform a wide range of functions such as signal processing, high-speed calculations, transmitting and receiving electromagnetic signals, controlling electronic devices, transforming sunlight to electricity, and creating visual images for television displays. Semiconductor devices are found in the fields of entertainment, communications, power conversion, networks, computers, and consumer products. Semiconductor devices are also found in military applications, aviation, automotive, industrial controllers, and office equipment.

Semiconductor devices exploit the electrical properties of semiconductor materials. The structure of semiconductor material allows the material's electrical conductivity to be manipulated by the application of an electric field or base current, or simply through the process of doping. Doping introduces impurities into the semiconductor material to manipulate and control the conductivity of the semiconductor device.

A semiconductor device contains active and passive electrical structures. Active structures, including bipolar and field effect transistors, control the flow of electrical current. By varying levels of doping and application of an electric field or base current, the transistor either promotes or restricts the flow of electrical current. Passive structures, including resistors, capacitors, and inductors, create a relationship between voltage and current necessary to perform a variety of electrical functions. The passive and active structures are electrically connected to form circuits, which enable the semiconductor device to perform high-speed operations and other useful functions.

Semiconductor devices are generally manufactured using two complex manufacturing processes, i.e., front-end manufacturing and back-end manufacturing, each involving potentially hundreds of steps. Front-end manufacturing involves the formation of a plurality of die on the surface of a semiconductor wafer. Each semiconductor die on a common wafer is typically identical and contains circuits formed by electrically connecting active and passive components. Back-end manufacturing involves singulating individual semiconductor die from the finished wafer and packaging the die to provide structural support, electrical interconnect, and environmental isolation. The term "semiconductor die" as used herein refers to both the singular and plural form of the words, and accordingly, can refer to both a single semiconductor device and multiple semiconductor devices.

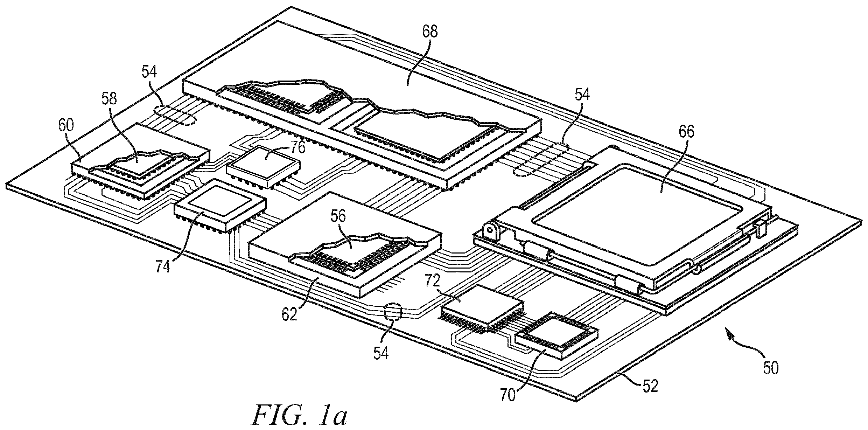

FIG. 1a illustrates electronic device 50 having a chip carrier substrate or printed circuit board (PCB) 52 with a plurality of semiconductor packages mounted on a surface of the PCB. Electronic device 50 can have one type of semiconductor package, or multiple types of semiconductor packages, depending on the application. Different types of semiconductor packages are shown in FIG. 1a for purposes of illustration.

Electronic device 50 can be a stand-alone system that uses the semiconductor packages to perform one or more electrical functions. Alternatively, electronic device 50 can be a subcomponent of a larger system. For example, electronic device 50 can be part of a tablet computer, cellular phone, digital camera, or other electronic device. Electronic device 50 can also be a graphics card, network interface card, or other expansion card that is inserted into a personal computer. The semiconductor packages can include microprocessors, memories, application specific integrated circuits (ASIC), programmable logic circuits, analog circuits, radio frequency (RF) circuits, discrete devices, or other semiconductor die or electrical components.

In FIG. 1a, PCB 52 provides a general substrate for structural support and electrical interconnect of the semiconductor packages mounted on the PCB. Conductive signal traces 54 are formed over a surface or within layers of PCB 52 using evaporation, electrolytic plating, electroless plating, screen printing, or other suitable metal deposition process. Signal traces 54 provide for electrical communication between each of the semiconductor packages, mounted components, and other external system components. Traces 54 also provide power and ground connections to each of the semiconductor packages. A clock signal is transmitted between semiconductor packages via traces 54 in one embodiment.

In some embodiments, a semiconductor device has two packaging levels. First level packaging is a technique for mechanically and electrically attaching the semiconductor die to an intermediate substrate. Second level packaging involves mechanically and electrically attaching the intermediate substrate to the PCB. In other embodiments, a semiconductor device may only have the first level packaging where the die is mechanically and electrically mounted directly to the PCB.

For the purpose of illustration, several types of first level packaging, including bond wire package 56 and flipchip 58, are shown on PCB 52. Additionally, several types of second level packaging, including ball grid array (BGA) 60, bump chip carrier (BCC) 62, land grid array (LGA) 66, multi-chip module (MCM) 68, quad flat non-leaded package (QFN) 70, quad flat package 72, embedded wafer level ball grid array (eWLB) 74, and wafer level chip scale package (WLCSP) 76 are shown mounted on PCB 52.

Depending upon the system requirements, any combination of semiconductor packages, configured with any combination of first and second level packaging styles, as well as other electronic components, can be connected to PCB 52. In some embodiments, electronic device 50 includes a single attached semiconductor package, while other embodiments call for multiple interconnected packages. By combining one or more semiconductor packages over a single substrate, manufacturers can incorporate pre-made components into electronic devices and systems. Because the semiconductor packages include sophisticated functionality, electronic devices can be manufactured using less expensive components and a streamlined manufacturing process. The resulting devices are less likely to fail and less expensive to manufacture resulting in a lower cost for consumers.

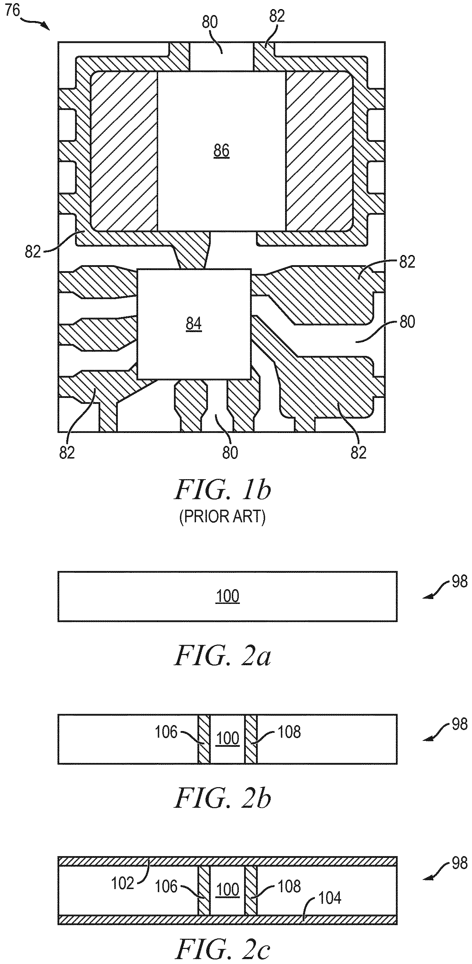

Many of the semiconductor devices packaged and mounted on PCB 52 use passive devices, such as inductors, capacitors, or resistors, to support or improve the functionality of the active circuits on a co-packaged semiconductor die. Passive devices can be discrete components or integrated passive devices (IPDs). Discrete components can be mounted separately on PCB 52 and connected to the packaged semiconductor devices as desired using traces 54. In other embodiments, such as illustrated in FIG. 1b, a discrete passive device is disposed on a leadframe substrate adjacent to a semiconductor device to enable the semiconductor device to utilize the passive device.

FIG. 1b illustrates a prior art semiconductor package 76. Package 76 is based on package substrate 80. Package substrate 80 has a conductive layer 82 formed on the package substrate to provide electrical connection between devices disposed on the package substrate and PCB 52. An integrated circuit (IC) or semiconductor component 84 is disposed over package substrate 80 and connected to conductive layer 82 using a flipchip connection. In another embodiment, IC 84 is connected to conductive layer 82 via bond wires. A passive device 86 is disposed over package substrate 80 adjacent to IC 84. Passive device 86 is connected between IC 84 and PCB 52 via conductive layer 82. Providing passive device 86 over package substrate 80 adjacent to IC 84 increases the size of package 76, and thus the footprint of package 76 on PCB 52. Larger package sizes reduces the ability for manufacturers to shrink the sizes of devices that include PCB 52.

### Summary

A need exists to decrease package size and manufacturing cost. Accordingly, in one embodiment, the present invention is a method of making a semiconductor device comprising the steps of providing a substrate, forming a first conductive layer over a first surface of the substrate, patterning the first conductive layer into a first portion of a first passive circuit element, forming a second conductive layer over a second surface of the substrate, patterning the second conductive layer into a second portion of the first passive circuit element, and disposing a semiconductor component over the substrate and electrically coupled to the first passive circuit element.

In another embodiment, the present invention is a method of making a semiconductor device comprising the steps of providing a substrate, forming a first conductive layer over a first surface of the substrate, patterning the first conductive layer to form a first portion of a first passive circuit element, and disposing a semiconductor component over the substrate and first passive circuit element with the semiconductor component electrically coupled to the first passive element.

In another embodiment, the present invention is a method of making a semiconductor device comprising the steps of providing a substrate, forming a first passive circuit element to include a portion of a first conductive layer formed over a first surface of the substrate, and disposing a semiconductor component over the first passive circuit element.

In another embodiment, the present invention is a semiconductor device comprising a substrate. A first conductive layer is disposed over a first surface of the substrate and patterned into a portion of a passive circuit element. A semiconductor component is disposed over the substrate and first conductive layer.

### Brief Description of the Drawings

FIGs. 1a-1b illustrate a PCB having semiconductor packages with passive devices;
FIGs. 2a-2o illustrate a method of forming a semiconductor package with passive components as a part of a leadframe substrate;
FIG. 3 illustrates a semiconductor package with multiple passive components as a part of a leadframe substrate;
FIGs. 4a-4e illustrate a leadframe substrate with stacked inductors coupled in series;
FIGs. 5a-5c illustrate a leadframe substrate with an integrated capacitor; and
FIG. 6 illustrates a resistive layer usable in a leadframe substrate.

### Detailed Description of the Drawings

The present invention is described in one or more embodiments in the following description with reference to the figures, in which like numerals represent the same or similar elements. While the invention is described in terms of the best mode for achieving objectives of the invention, those skilled in the art will appreciate that the disclosure is intended to cover alternatives, modifications, and equivalents as may be included within the spirit and scope of the invention as defined by the appended claims and claim equivalents as supported by the following disclosure and drawings.

FIGs. 2a-2o illustrate a manufacturing process for forming a leadframe substrate 98, and a semiconductor package including leadframe substrate 98. Formation of leadframe substrate 98 begins with a base substrate 100. Base substrate 100 is formed from a base insulating material such as polymer, polymer composite, ceramic, glass, glass epoxy, beryllium oxide, or other suitable rigid material for structural support. Alternatively, base substrate 100 can be one or more layers of polytetrafluoroethylene pre-impregnated (prepreg), FR-4, FR-1, CEM-1, or CEM-3 with a combination of phenolic cotton paper, epoxy, resin, woven glass, matte glass, polyester, inorganic fillers, and other reinforcement fibers or fabrics. In some embodiments, base substrate 100 is provided as a sheet large enough to form a plurality of leadframe substrates 98 side-by-side. Each individual leadframe substrate 98 is formed in unison as shown in FIGs. 2a-2o, followed by a singulation step to separate the devices for sale and distribution.

In FIG. 2b, conductive vias 106 and 108 are formed through base substrate 100. First, an opening is formed through base substrate 100 using laser drilling, mechanical drilling, deep reactive ion etching (DRIE), or other suitable process. In one embodiment, the openings for conductive vias 106 and 108 are formed using wet/dry etching. In another embodiment, the openings for conductive vias 106 and 108 are formed by laser direct ablation (LDA). Additional conductive vias are formed through base substrate 100 as needed for a particular embodiment.

The openings through base substrate 100 are filled with aluminum (Al), copper (Cu), tin (Sn), nickel (Ni), gold (Au), silver (Ag), titanium (Ti), tungsten (W), or other suitable electrically conductive material or combination thereof using PVD, CVD, electrolytic plating, electroless plating, or other suitable metal deposition process to form conductive vias 106 and 108. Conductive vias 106 and 108 extend to both a top and a bottom surface of base substrate 100. In some embodiments, base substrate 100 is planarized using chemical mechanical planarization (CMP), mechanical planarization, or other suitable process so that a top surface of base substrate 100 is coplanar with top surfaces of conductive vias 106 and 108, and a bottom surface of base substrate 100 is coplanar with bottom surfaces of conductive vias 106 and 108.

In FIG. 2c, An electrically conductive layer 102 is formed over a top surface of base substrate 100 using a patterning and metal deposition process such as printing, PVD, CVD, sputtering, electrolytic plating, electroless plating, metal evaporation, metal sputtering, or other suitable metal deposition process. An electrically conductive layer 104 is formed over a bottom surface of base substrate 100 using a patterning and metal deposition process such as printing, PVD, CVD, sputtering, electrolytic plating, electroless plating, metal evaporation, metal sputtering, or other suitable metal deposition process. Conductive layers 102 and 104 are one or more layers of Al, Cu, Sn, Ni, Au, Ag, or other suitable electrically conductive material in various embodiments. In one embodiment, conductive layers 102 and 104 are Cu foil laminated over base substrate 100. In other embodiments, base substrate 100 and conductive layers 102 and 104 are initially provided to a manufacturer of leadframe substrate 98 as a copper clad laminate (CCL).

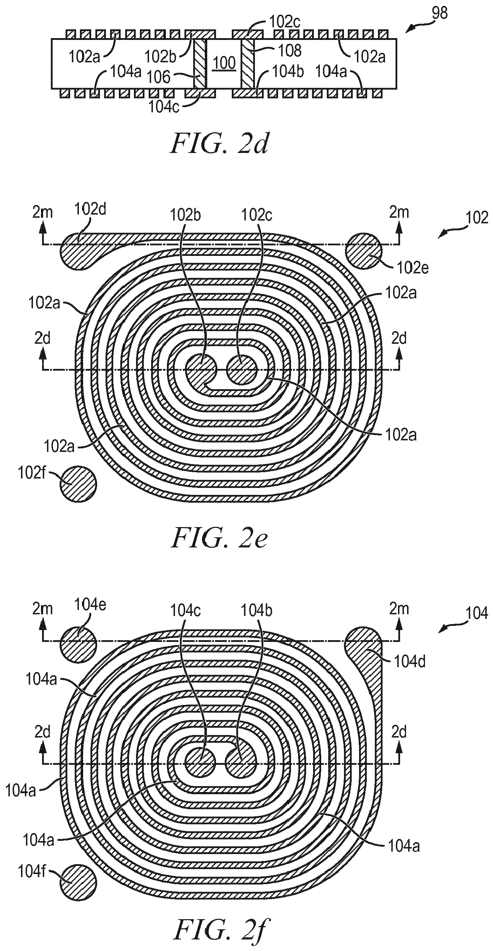

FIG. 2d illustrates conductive layers 102 and 104 patterned to form inductive circuit elements. Conductive layers 102 and 104 are patterned using a photoresist with wet etching, DRIE, LDA, or other suitable process. FIG. 2e illustrates a plan view of conductive layer 102 after patterning, and FIG. 2f illustrates a plan view of conductive layer 104 after patterning, both as viewed from above FIG. 2d. After etching, conductive layers 102 and 104 are two inductors in close proximity to each other, and exhibit mutual inductance.

Conductive layer 102 includes winding 102a and contact pads 102b-102f. Winding 102a provides inductance as electric current flows between contact pads 102b and 102d through the winding. Contact pad 102b is formed at an inside end of winding 102a, and contact pad 102d is formed at an outside end of winding 102a. Contact pads 102b and 102d are connected by winding 102a. Conductive layer 104 includes winding 104a and contact pads 104b-104f. Winding 104a provides inductance as electric current flows between contact pads 104b and 104d. Contact pad 104b is formed at an inside end of winding 104a, and contact pad 104d is formed at an outside end of winding 104a. Contact pads 104b and 104d are connected by winding 104a.

Contact pads 102c, 102e, 102f, 104c, 104e, and 104f are dummy contact pads that are used to increase registration or alignment tolerance of subsequently formed conductive vias relative to conductive vias 106 and 108 and other conductive vias formed through base substrate 100. Conductive via 106 electrically couples contact pad 102b to contact pad 104c through base substrate 100. Conductive via 108 electrically couples contact pad 102c to contact pad 104b through base substrate 100. Additional conductive vias through base substrate 100, similar to conductive vias 106 and 108, couple contact pad 102d to contact pad 104e, contact pad 102e to contact pad 104d, and contact pad 102f to contact pad 104f.

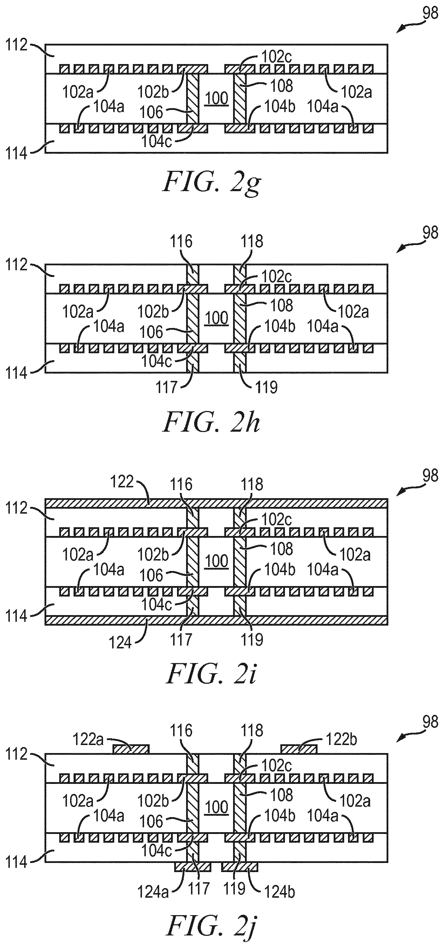

In FIG. 2g, insulating layer 112 is conformally applied to, and has a first surface oriented toward, base substrate 100 that follows the contours of conductive layer 102. Insulating layer 112 has a second planar surface opposite base substrate 100. Similarly, insulating layer 114 is conformally applied to, and has a first surface oriented toward, base substrate 100 that follows the contours of conductive layer 104. Insulating layer 114 has a second planar surface opposite base substrate 100. Insulating layers 112 and 114 each contain one or more layers of prepreg, photosensitive low curing temperature dielectric resist, photosensitive composite resist, liquid crystal polymer (LCP), laminate compound film, insulation paste with filler, solder mask resist film, liquid molding compound, granular molding compound, polyimide, benzocyclobutene (BCB), polybenzoxazoles (PBO), silicon dioxide (SiO2), silicon nitride (Si3N4), silicon oxynitride (SiON), tantalum pentoxide (Ta2O5), aluminum oxide (Al2O3), or other material having similar insulating and structural properties. Insulating layers 112 and 114 are deposited using printing, spin coating, spray coating, lamination, or other suitable process. In some embodiments, a planarization process, such as CMP, is performed on the surfaces of insulating layers 112 and 114 opposite base substrate 100.

FIG. 2h illustrates conductive vias 116 and 118 formed through insulating layer 112. Conductive vias 117 and 119 are formed through insulating layer 114. Conductive vias 116, 117, 118, and 119 are formed using a similar process as conductive vias 106 and 108. Conductive via 116 extends from an exposed surface of insulating layer 112 to contact pad 102b. Conductive via 118 extends from an exposed surface of insulating layer 112 to contact pad 102c. Conductive via 117 extends from an exposed surface of insulating layer 114 to contact pad 104c. Conductive via 119 extends from an exposed surface of insulating layer 114 to contact pad 104b.

Conductive via 116 is electrically connected to conductive via 117 by contact pad 102b, conductive via 106, and contact pad 104c. Conductive via 118 is electrically connected to conductive via 119 by contact pad 102c, conductive via 108, and contact pad 104b. Contact pads 102b, 102c, 104b, and 104c increase the acceptable misalignment during formation of vias 116, 117, 118, and 119 by increasing the footprint of conductive material when forming openings through insulating layers 112 and 114. As seen in FIGs. 2e and 2f, contact pads 102c and 104c are electrically isolated from other portions of their respective conductive layers, so conductive vias 106, 116, and 117 are not directly electrically connected to conductive vias 108, 118, and 119 through conductive layers 102 or 104.

Additional conductive vias are formed through insulating layers 112 and 114 in various embodiments as necessary to couple to or through leadframe substrate 98 and between portions of passive circuit elements formed on layers in leadframe substrate 98. In the illustrated embodiment, additional conductive vias are formed through insulating layer 112 over contact pads 102d, 102e, and 102f, and through insulating layer 114 over contact pads 104d, 104e, and 104f.

FIG. 2i illustrates conductive layer 122 formed over insulating layer 112, and conductive layer 124 formed over insulating layer 114. Conductive layers 122 and 124 are formed in a similar manner to conductive layers 102 and 104 in FIG. 2c. FIG. 2j illustrates contact pads 122a and 122b of conductive layer 122 after conductive layer 122 is etched or patterned in a similar manner to conductive layer 102. FIG. 2j further shows contact pads 124a and 124b of conductive layer 124 after conductive layer 124 is etched or patterned in a similar manner to conductive layer 104.

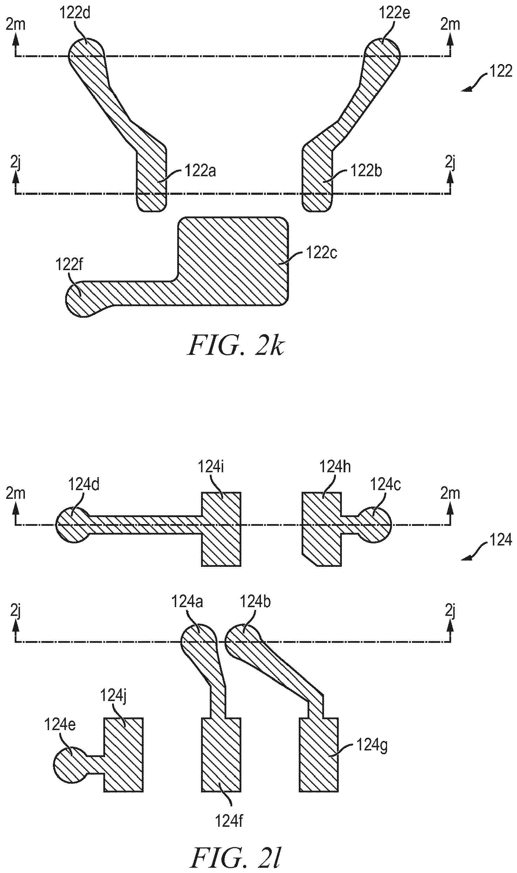

FIG. 2k illustrates conductive layer 122 in a plan view after conductive layer 122 is patterned, and FIG. 2l illustrates conductive layer 124 in plan view after patterning. Mounting pad 122c is provided for a semiconductor component or integrated circuit to be subsequently mounted on leadframe substrate 98. The semiconductor component on mounting pad 122c is coupled to contact pads 122a and 122b by wire bonding. In other embodiments, a semiconductor device is flip-chipped onto conductive layer 122.

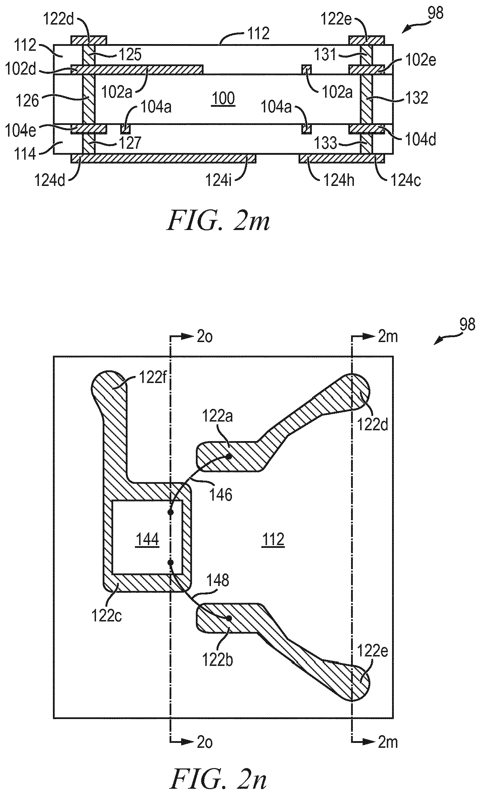

A conductive via 125 through insulating layer 112 under contact pad 122d, seen in FIG. 2m, completes a connection between contact pad 122a to contact pad 102d. Conductive via 126 through base substrate 100 and conductive via 127 through insulating layer 114 further connect contact pad 102d to contact pad 124d, as shown in FIG. 2m. Contact pads 122d and 124d are vertically aligned on opposite sides of leadframe substrate 98.

Conductive via 131 through insulating layer 112 and conductive via 132 through base substrate 100 under contact pad 122e connect contact pad 122b to contact pad 104d. An additional conductive via 133 through insulating layer 114 connects contact pad 104d to contact pad 124c. Contact pads 122e and 124c are vertically aligned on opposite sides of leadframe substrate 98.

Conductive layer 124, as patterned in FIG. 2l, provides external contacts for a semiconductor package formed with leadframe substrate 98. Contact pads 124f, 124g, 124h, 124i, and 124j are contact pads for external interconnect. Solder bumps or other interconnect structures formed over contact pads 124f-124j are coupled to corresponding contact pads on PCB 52 to connect the device to other circuits on the PCB. Contact pads 124a-124e provide interconnection from contact pads 124f-124j to conductive layers 102, 104, and 122.

FIG. 2n illustrates a semiconductor component 144 disposed over mounting pad 122c. In one embodiment, semiconductor component 144 is a transient voltage suppression (TVS) diode, and conductive layers 102-104 form a common mode choke for the TVS diode. TVS diode 144 includes a first terminal coupled to contact pad 122a by bond wire 146, and a second terminal coupled to contact pad 122b by bond wire 148.

The first terminal of TVS diode 144 is electrically coupled to contact pad 124f through winding 102a for external interconnect as follows. TVS diode 144 is electrically coupled to contact pad 122a by bond wire 146. Contact pad 122a is further electrically coupled to contact pad 122d by conductive layer 122. Contact pad 122d is coupled to contact pad 102d by conductive via 125. Contact pad 102d is coupled to contact pad 102b by winding 102a. Winding 102a is coupled to contact pad 102b at an opposite end of the winding from contact pad 102d. Contact pad 102b is coupled down to contact pad 124a by conductive via 106, contact pad 104c, and conductive via 117. Contact pad 124a is coupled out to contact pad 124f for subsequent external interconnect to PCB 52 or another device. Contact pad 124f provides external interconnect to TVS diode 144 via winding 102a.

The second terminal of TVS diode 144 is electrically coupled to contact pad 124g through winding 104a for external interconnect as follows. TVS diode 144 is electrically coupled to contact pad 122b by bond wire 148. Contact pad 122b is further electrically coupled to contact pad 122e by conductive layer 122. Contact pad 122e is coupled to contact pad 104d by conductive via 131, contact pad 102e, and conductive via 132. Contact pad 104d is coupled to contact pad 104b by winding 104a. Winding 104a is coupled to contact pad 104b at an opposite end of the winding from contact pad 104d. Contact pad 104b is coupled down to contact pad 124b by conductive via 119. Contact pad 124b is coupled out to contact pad 124g for subsequent external interconnect. Contact pad 124g provides external interconnect to TVS diode 144 via winding 104a.

Contact pads 124f and 124g provide external interconnection to TVS 144 via windings 102a and 104a, respectively. Windings 102a and 104a are inductors that operate as a choke integrated into leadframe substrate 98. An external system can also couple to TVS 144 directly, without windings 102a and 104a, using contact pads 124h and 124i. Contact pad 124i is coupled to TVS 144 through contact pad 124d, conductive via 127, contact pad 104e, conductive via 126, contact pad 102d, conductive via 125, contact pad 122d, contact pad 122a, and bond wire 146. Contact pad 124h is coupled to TVS 144 through contact pad 124c, conductive via 133, contact pad 104d, conductive via 132, contact pad 102e, conductive via 131, contact pad 122e, contact pad 122b, and bond wire 148.

An external system accesses TVS 144 through the choke formed with windings 102a and 104a by connecting to contact pads 124f and 124g, or accesses TVS 144 directly by connecting to contact pads 124h and 124i. Direct access to TVS 144 via contact pads 124h and 124i allows testing of TVS 144. An external system also couples to a body contact of TVS 144 using contact pad 124j. Contact pad 124j is coupled to contact pad 124e, which is coupled to contact pads 104f, 102f, and 122f by conductive vias not illustrated. Contact pad 122f is coupled to mounting pad 122c which is coupled to a body or bulk substrate contact of TVS 144.

After TVS 144 is mounted to mounting pad 122c and coupled to contact pads 122a and 122b by bond wires 146 and 148, an insulating encapsulant or molding compound 150 is deposited over TVS 144 and leadframe substrate 98 using a paste printing, compressive molding, transfer molding, liquid encapsulant molding, vacuum lamination, spin coating, or other suitable applicator. In particular, encapsulant 150 is disposed over and around TVS 144. Encapsulant 150 includes polymer composite material, such as epoxy resin with filler, epoxy acrylate with filler, or polymer with proper filler. Encapsulant 150 is nonconductive and environmentally protects the semiconductor device from external elements and contaminants.

In some embodiments, an additional insulating layer is formed over insulating layer 114 and conductive layer 124. Openings are formed in the additional insulating layer to expose contact pads 124f-124j for external interconnection. In embodiments where leadframe substrate 98 is formed as a sheet including a plurality of adjacent windings 102a and 104a, leadframe substrate 98 is singulated into individual TVS packages 151 and stored in a tape and reel for distribution.

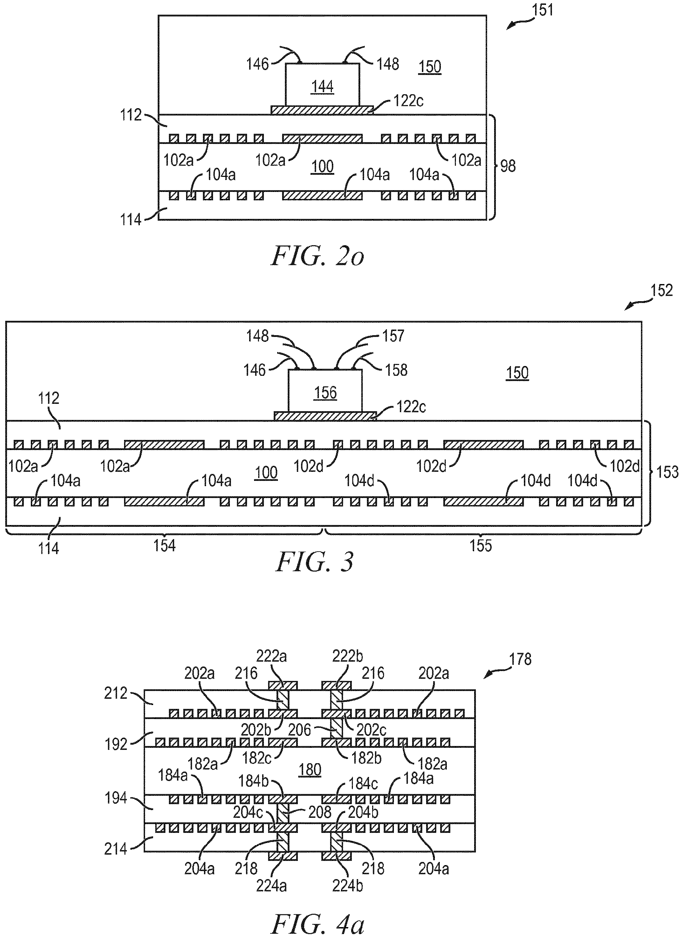

FIG. 2o illustrates a singulated TVS package 151 with encapsulant 150. TVS package 151 includes leadframe substrate 98 with an integrated choke formed by winding 102a and winding 104a. Leadframe substrate 98 also provides direct connection to TVS diode 144 without routing electric current through winding 102a and winding 104a. TVS package 151 saves real estate by integrating desired passive circuit elements, e.g., a choke, into leadframe substrate 98, rather than disposing the passive circuit elements over a leadframe substrate adjacent to TVS diode 144. No separate passive circuit element is provided on leadframe substrate 98 in addition to TVS diode 144, saving processing steps, reducing manufacturing cost, and improving performance. In other embodiments, other types of passive devices are formed by conductive layers 102 and 104, or additional conductive layers formed over base substrate 100. Other types of passive devices that are formed include but are not limited to capacitors, resistors, and antennas.

FIG. 3 illustrates a TVS package 152 including leadframe substrate 153. Leadframe substrate 153 includes a first common mode choke 154 and a second common mode choke 155. Semiconductor die 156 includes two TVS diodes on a single die. A first TVS diode is coupled to common mode choke 154 by bond wires 146 and 148. A second TVS diode of semiconductor die 156 is coupled to common mode choke 155 by bond wires 157 and 158. TVS package 152 includes two TVS diodes, with each having a separate common mode choke formed as a part of leadframe substrate 153. Choke 155 is formed adjacent to, and outside a footprint of, choke 154.

Chokes 154 and 155 are formed by a similar process to the process shown in FIGs. 2a-2o, but are singulated in pairs rather than each choke being singulated separately. A leadframe substrate may include a plurality of passive devices other than just chokes formed side-by-side on base substrate 100. Passive devices are formed in any useful combination, and in any appropriate number, over base substrate 100 and packaged along with a semiconductor die for use on PCB 52. In one embodiment, choke 154 is formed over base substrate 100 as in FIG. 3, while choke 155 is replaced by a capacitor, resistor, antenna, or other passive device. Other combinations of passive devices are formed as a part of leadframe substrate 153 in other embodiments.

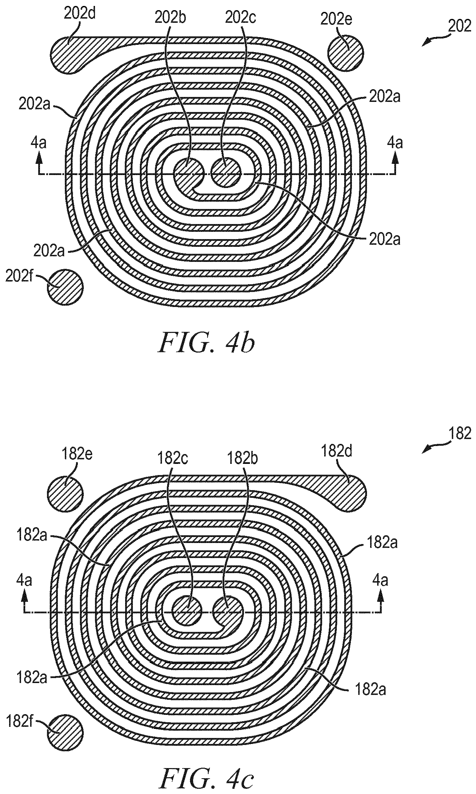

FIGs. 4a-4e illustrate a choke with each inductor of the choke formed as multiple layers to increase the number of windings of each inductor. FIG. 4a is a cross-sectional view of a leadframe substrate 178. Leadframe substrate 178 includes a base substrate 180, similar to base substrate 100 of leadframe substrate 98. Conductive vias, similar to conductive vias 106, 108, 126, and 128 are formed through base substrate 180 as necessary to connect conductive layers on the top of base substrate 180 to conductive layers on the bottom of base substrate 180. While no conductive vias are illustrated in the cross-section of FIG. 4a, conductive vias are formed through other areas of base substrate 180 as explained with reference to FIGs. 4b-4e.

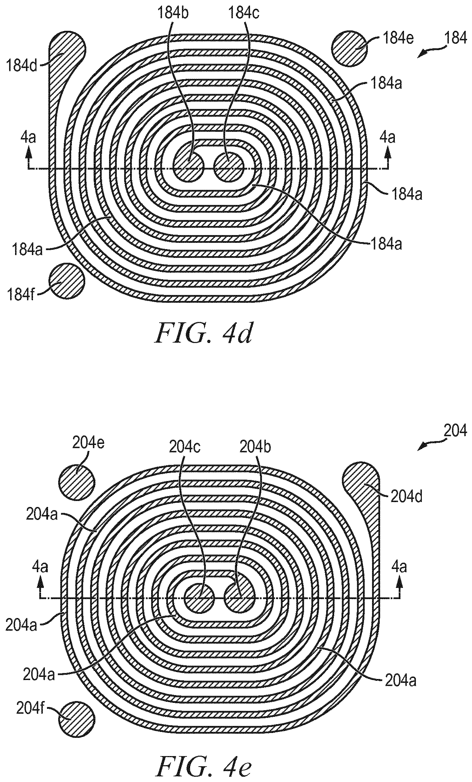

Conductive layer 182 is formed on a top surface of base substrate 180, and conductive layer 184 is formed on a bottom surface of base substrate 180. Conductive layers 182 and 184 are patterned into windings and a plurality of contact pads similar to conductive layers 102 and 104. FIG. 4c illustrates conductive layer 182 in plan view after being patterned, including winding 182a and contact pads 182b-182f. FIG. 4d illustrates conductive layer 184 in plan view after being patterned, including winding 184a and contact pads 184b-184f. Conductive layer 182 is covered with insulating layer 192, and conductive layer 184 is covered with insulating layer 194. Insulating layers 192 and 194 are similar to insulating layers 112 and 114. Conductive vias 206 and 208 are formed through insulating layers 212 and 214 as necessary to connect conductive layers 182 and 184 to subsequently formed conductive layers.

Leadframe substrate 178 includes additional conductive layers 202 and 204 formed over insulating layers 192 and 194, respectively. Conductive layers 202 and 204 are patterned to provide additional windings, 202a and 204a, that are connected in series with windings 184a and 182a, respectively. FIG. 4b illustrates conductive layer 202 in plan view, including winding 202a and contact pads 202b-202f. FIG. 4e illustrates conductive layer 204 in plan view, including winding 204a and contact pads 204b-204f. Insulating layers 212 and 214 are formed over conductive layers 202 and 204, similar to insulating layers 192 and 194. Conductive vias 216 and 218 are formed through insulating layers 212 and 214 as necessary to couple conductive layers 202 and 204 to subsequently formed conductive layers.

Conductive layer 222 is formed over insulating layer 212. Conductive layer 222 includes contact pads 222a and 222b, as well as a mounting pad and additional wire bond pads or other means for mounting and connecting an integrated circuit. Conductive layer 222 in FIG. 4a is similar to conductive layer 122 in FIGs. 2a-2o. Conductive layer 224 includes pads 224a and 224b, as well as other contact pads useful for connecting leadframe substrate 178 to external systems. Conductive layer 224 is similar to conductive layer 124 in FIGs. 2a-2o.

Contact pad 222a is connected to contact pad 224a through windings 202a and 184a coupled in series. A conductive via 216 couples contact pad 222a through insulating layer 212 to contact pad 202b. Contact pad 202b is shown in FIG. 4b. Winding 202a routes electric current between contact pad 202b and contact pad 202d. A conductive via 206 connects contact pad 202d down through insulating layer 192 to contact pad 182e of FIG. 4c. Contact pad 182e is electrically isolated from winding 182a. A conductive via couples contact pad 182e through base substrate 180 to contact pad 184d of FIG. 4d. Winding 184a couples contact pad 184d to contact pad 184b. A conductive via 208 couples contact pad 184b down to contact pad 204c of FIG. 4e. Contact pad 204c is electrically isolated from winding 204a. A conductive via 218 couples contact pad 204c down to contact pad 224a. Conductive layer 224 routes electric current from contact pad 224a as desired for interconnection to PCB 52.

Winding 184a is coupled in series with winding 202a. Winding 184a routes electric current in a rotation with the same turn direction as winding 202a. Current flowing counter-clockwise in winding 202a of FIG. 4b from contact pad 202b to contact pad 202d is connected down to contact pad 184d in FIG. 4d and continues flowing counter-clockwise through winding 184a to contact pad 184b. Current also flows the opposite direction, i.e., clockwise, through both windings 184a and 202a in series.

Contact pad 222b is coupled to contact pad 224b through windings 182a and 204a in series. A conductive via 216 couples contact pad 222b to contact pad 202c of FIG. 4b. Contact pad 202c is electrically isolated from winding 202a. A conductive via 206 couples contact pad 202c down to contact pad 182b of FIG. 4c. Winding 182a couples contact pad 182b to contact pad 182d. A conductive via couples contact pad 182d to contact pad 184e of FIG. 4d through base substrate 180. Contact pad 184e is electrically isolated from winding 184a. A conductive via 208 further couples contact pad 184e to contact pad 204d in FIG. 4e. Contact pad 204d is coupled to contact pad 204b by winding 204a. Contact pad 204b is coupled to contact pad 224b by a conductive via 218. Conductive layer 224 routes electric current from contact pad 224b as desired for interconnection to PCB 52 or other external system. Windings 182a and 204a are wired in series and route electric current in the same rotational direction, similar to windings 202a and 184a.

Contact pads 182c, 182e, 182f, 184c, 184e, 184f, 202c, 202e, 202f, 204c, 204e, and 204f are electrically isolated from the windings of their respective conductive layers, and are used to increase alignment tolerance of conductive vias formed through insulating layers 192, 194, 212, and 214.

Adding more conductive and insulating layers over base substrate 180 allows additional passive devices to be formed in a stacked configuration. Additional passive devices are coupled in series or in parallel in various embodiments. In other embodiments, multiple passive devices formed over base substrate 180 are each coupled to a different terminal of an integrated circuit, and not directly connected to each other.

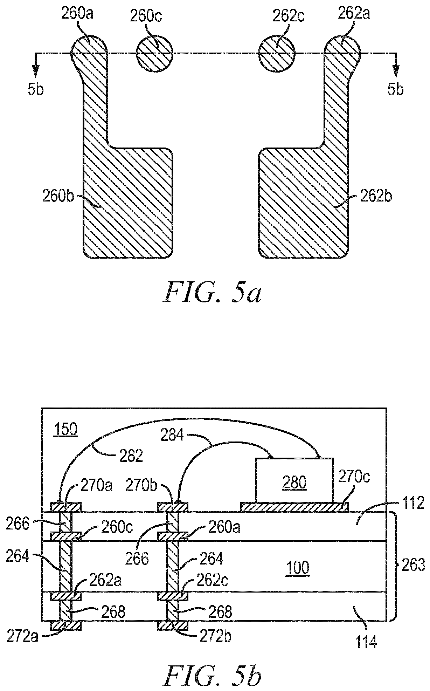

FIGs. 5a-5c illustrate conductive layers used to form a capacitor over base substrate 100. FIG. 5a illustrates a plan view of conductive layers 260 and 262. Conductive layer 260 includes contact pad 260a, coupled to plate 260b, and contact pad 260c, which is electrically isolated from plate 260b. Conductive layer 262 includes contact pad 262a, coupled to plate 262b, and contact pad 262c, which is electrically isolated from plate 262b. Plates 260b and 262b comprise plates of a capacitor formed on opposite sides of base substrate 100.

FIG. 5b illustrates leadframe substrate 263 including conductive layers 260 and 262 formed on base substrate 100 as a capacitor. Contact pad 260c is coupled through base substrate 100 to contact pad 260a by a conductive via 264. Contact pad 260a is coupled through base substrate 100 to contact pad 262c by a conductive via 264. Insulating layer 112 is formed over conductive layer 260, and insulating layer 114 is formed over conductive layer 262. A plurality of conductive vias 266 is formed through insulating layer 112. A plurality of conductive vias 268 is formed through insulating layer 114.

Conductive layer 270 is formed over insulating layer 112, and includes contact pad 270a, contact pad 270b, and mounting pad 270c. Conductive layer 272 is formed over insulating layer 114 for external interconnect, and includes contact pads 272a and 272b over conductive vias 268. IC 280 is disposed on mounting pad 270c to provide desired functionality. IC 280 is coupled to contact pad 270a by bond wire 282, and to contact pad 270b by bond wire 284. Bond wire 282 is coupled directly to contact pad 272a through contact pad 270a, conductive via 266, contact pad 260c, conductive via 264, contact pad 262a, and conductive via 268. Bond wire 284 is coupled directly to contact pad 272b through contact pad 270b, conductive via 266, contact pad 260a, conductive via 264, contact pad 262c, and conductive via 268. Plate 260b of conductive layer 260 is coupled to bond wire 284 via contact pad 260a, and plate 262b of conductive layer 262 is coupled to bond wire 282 via contact pad 262a.

Plates 260b and 262b operate as plates of a capacitor that provide an increased capacitance between terminals of IC 280. Conductive layers 260 and 262 are used in conjunction with conductive layers 102 and 104 in some embodiments to provide both a capacitive and inductive element on a single leadframe substrate.

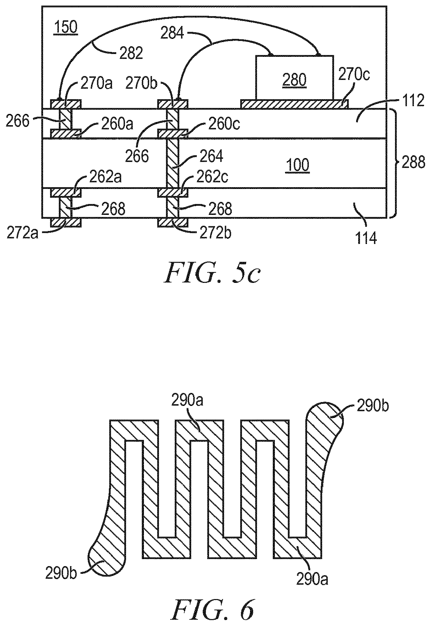

FIG. 5c illustrates leadframe substrate 288 with conductive layer 260 and 262 used to provide a capacitor in series between IC 280 and an externally available contact of conductive layer 272. Conductive layer 260 is flipped over so that bond wire 282 is coupled to contact pad 260a rather than 260c. Contact pad 260a is not coupled to contact pad 262a by a conductive via 264. Rather, contact pad 260a is coupled to contact pad 262a by an electric field between plate 260b and plate 262b, which operate as two plates of a capacitor. Contact pad 270b remains connected directly to contact pad 272a through a conductive via 266, contact pad 260c, conductive via 264, contact pad 262c, and conductive via 268. In some embodiments, a capacitor is formed on a single conductive layer 260 or 262, by providing two portions of a common conductive layer that are electrically isolated but close enough to each other to exhibit significant electrical capacitance.

FIG. 6 illustrates a resistive layer 290. Resistive layer 290 is patterned to include a resistive portion 290a that is shaped to increase the conduction length for electrical current flowing between contact pads 290b. Resistive portion 290a is formed from a material and at a length calculated to provide a desired electrical resistance between contact pads 290b. Resistive layer 290 is formed as an additional conductive layer on any of the previously disclosed leadframe substrate embodiments. Resistive layer 290 is used with capacitors formed from conductive layers 260 and 262, and with inductors similar to conductive layers 102 and 104, in any combination as desired for a specific device that requires passive components.

Terms of relative position as used in this description are defined based on a plane parallel to the conventional plane or working surface of a wafer or substrate, regardless of the orientation of the wafer or substrate. The term "horizontal" or "lateral" as used in this application is defined as a plane parallel to the conventional plane or working surface of a wafer or substrate, regardless of the orientation of the wafer or substrate. The term "vertical" refers to a direction perpendicular to the horizontal. Terms such as "on," "side" (as in "sidewall"), "higher," "lower," "over," "top," and "under" are defined with respect to the conventional plane or working surface being on the top surface of the wafer or substrate, regardless of the orientation of the wafer or substrate.

While one or more embodiments of the present invention have been illustrated in detail, the skilled artisan will appreciate that modifications and adaptations to those embodiments may be made without departing from the scope of the present invention as set forth in the following claims.

**The following is a list of preferred embodiments:**
Embodiment 1. A method of making a semiconductor device, comprising:
   providing a substrate;
   forming a first conductive layer over a first surface of the substrate;
   patterning the first conductive layer into a first portion of a first passive circuit element;
   forming a second conductive layer over a second surface of the substrate;
   patterning the second conductive layer into a second portion of the first passive circuit element; and
   disposing a semiconductor component over the substrate and electrically coupled to the first passive circuit element.
Embodiment 2. The method of embodiment 1, further including:
   patterning the first conductive layer to include a first coiled portion; and
   patterning the second conductive layer to include a second coiled portion exhibiting a mutual inductance with the first coiled portion.
Embodiment 3. The method of embodiment 1, further including patterning the first conductive layer to include a plate of a capacitor.
Embodiment 4. The method of embodiment 1, further including depositing an encapsulant over the semiconductor component and substrate.
Embodiment 5. The method of embodiment 4, further including mounting the substrate to a printed circuit board (PCB).
Embodiment 6. The method of embodiment 1, further including:
   patterning the first conductive layer to include an inductive element; and
   patterning the second conductive layer to include a capacitive element.
Embodiment 7. A method of making a semiconductor device, comprising:
   providing a substrate;
   forming a first conductive layer over a first surface of the substrate;
   patterning the first conductive layer to form a first portion of a first passive circuit element; and
   disposing a semiconductor component over the substrate and first passive circuit element with the semiconductor component electrically coupled to the first passive element.
Embodiment 8. The method of embodiment 7, further including patterning the first conductive layer to form a coil.
Embodiment 9. The method of embodiment 7, further including patterning the first conductive layer to form a portion of a capacitor.
Embodiment 10. The method of embodiment 7, further including:
   forming a second conductive layer over the first conductive layer; and
   disposing the semiconductor component on the second conductive layer.
Embodiment 11. The method of embodiment 7, further including patterning the first conductive layer to form a plurality of contact pads.
Embodiment 12. The method of embodiment 7, further including
   forming a second conductive layer over the first conductive layer; and
   patterning the second conductive layer to form a first portion of a second passive circuit element.
Embodiment 13. The method of embodiment 7, further including patterning the first conductive layer to include an antenna.
Embodiment 14. A method of making a semiconductor device, comprising:
   providing a substrate;
   forming a first passive circuit element to include a portion of a first conductive layer formed over a first surface of the substrate; and
   disposing a semiconductor component over the first passive circuit element.
Embodiment 15. The method of embodiment 14, further including forming the first passive circuit element to include a portion of a second conductive layer formed over a second surface of the substrate.
Embodiment 16. The method of embodiment 15, further including:
   forming the portion of the first conductive layer to include a first coil; and
   forming the portion of the second conductive layer to include a second coil coupled in series with the first coil.
Embodiment 17. The method of embodiment 14, further including:
   depositing an encapsulant over the substrate and semiconductor component; and
   mounting the substrate to a printed circuit board (PCB).
Embodiment 18. The method of embodiment 14, further including patterning the portion of the first conductive layer to include a coil.
Embodiment 19. The method of embodiment 14, further including forming a second passive circuit element to include a portion of a second conductive layer formed over the first conductive layer.
Embodiment 20. A semiconductor device, comprising:
   a substrate;
   a first conductive layer disposed over a first surface of the substrate and patterned into a portion of a passive circuit element; and
   a semiconductor component disposed over the substrate and first conductive layer.
Embodiment 21. The semiconductor device of embodiment 20, further including a second conductive layer disposed over a second surface of the substrate and patterned into a second portion of the passive circuit element.
Embodiment 22. The semiconductor device of embodiment 21, further including a conductive via formed through the substrate and coupled between the first conductive layer and second conductive layer.
Embodiment 23. The semiconductor device of embodiment 20, further including a second conductive layer disposed over the first conductive layer, wherein the semiconductor component is mounted onto the second conductive layer.
Embodiment 24. The semiconductor device of embodiment 20, wherein the passive circuit element includes an inductor, capacitor, resistor, or antenna.
Embodiment 25. The semiconductor device of embodiment 20, further including an encapsulant deposited over the substrate and semiconductor component.

## Claims

1. A method of making a semiconductor device, comprising:
providing a substrate;
forming a first conductive layer over a first surface of the substrate;
patterning the first conductive layer into a first portion of a first passive circuit element; and
disposing a semiconductor component over the substrate and electrically coupled to the first passive circuit element.

2. The method of claim 1, further including:
forming a second conductive layer over a second surface of the substrate; and
patterning the second conductive layer into a second portion of the first passive circuit element.

3. The method of claim 2, further including:
patterning the first conductive layer to include a first coiled portion; and
patterning the second conductive layer to include a second coiled portion exhibiting a mutual inductance with the first coiled portion.

4. The method of claims 1 or 2, further including patterning the first conductive layer to include a plate of a capacitor.

5. The method of any one of claims 1 to 4, further including depositing an encapsulant over the semiconductor component and substrate.

6. The method of claim 5, further including mounting the substrate to a printed circuit board (PCB).

7. A semiconductor device, comprising:
a substrate;
a first conductive layer disposed over a first surface of the substrate and patterned into a portion of a passive circuit element; and
a semiconductor component disposed over the substrate and electrically coupled to the first conductive layer.

8. The semiconductor device of claim 7, further including a second conductive layer disposed over a second surface of the substrate and patterned into a second portion of the passive circuit element.

9. The semiconductor device of claim 8, further including a conductive via formed through the substrate and coupled between the first conductive layer and second conductive layer.

10. The semiconductor device of claim 7, further including a second conductive layer disposed over the first conductive layer, wherein the semiconductor component is mounted onto the second conductive layer.

11. The semiconductor device of any one of claims 7 to 10, wherein the passive circuit element includes an inductor, capacitor, resistor, or antenna.

12. The semiconductor device of any one of claims 7 to 10, wherein the portion of the passive circuit element includes a coil.

13. The semiconductor device of any one of claims 7 to 10, wherein the portion of the passive circuit element includes a plate of a capacitor.
